(19) Europäisches Patentamt
European Patent Office
Office européen des brevets

(11) **EP 3 008 479 B1**

(12) **FASCICULE DE BREVET EUROPEEN**

(45) Date de publication et mention
de la délivrance du brevet:
**23.10.2019 Bulletin 2019/43**

(21) Numéro de dépôt: **14728139.8**

(22) Date de dépôt: **26.05.2014**

(51) Int Cl.:
***G01R 31/11*** *(2006.01)*      ***G01R 31/08*** *(2006.01)*

(86) Numéro de dépôt international:
**PCT/EP2014/060850**

(87) Numéro de publication internationale:
**WO 2014/198526 (18.12.2014 Gazette 2014/51)**

(54) **PROCEDE DE REFLECTOMETRIE POUR L'IDENTIFICATION DE DEFAUTS NON FRANCS IMPACTANT UN CABLE**

REFLEKTOMETRIEVERFAHREN ZUR IDENTIFIKATION VON SCHWACHSTELLEN EINES KABELS

REFLECTOMETRY METHOD FOR IDENTIFYING SOFT FAULTS AFFECTING A CABLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.06.2013 FR 1355377**

(43) Date de publication de la demande:
**20.04.2016 Bulletin 2016/16**

(73) Titulaire: **Commissariat à l'Énergie Atomique et aux Énergies Alternatives 75015 Paris (FR)**

(72) Inventeurs:
• **COHEN, Josy**
  **F-94420 Le Plessis Trevise (FR)**
• **GREGIS, Nicolas**
  **F-94260 Fresnes (FR)**

(74) Mandataire: **Hammes, Pierre Marks & Clerk France Immeuble Visium 22, avenue Aristide Briand 94117 Arcueil Cedex (FR)**

(56) Documents cités:
**FR-A1- 2 964 746         US-A1- 2002 105 912
US-A1- 2005 156 585      US-A1- 2005 234 662**

• **Paolo F Fantoni: "Overview of the Halden Reactor Project Activities on Cable Aging Management and Condition Monitoring", , 2 octobre 2011 (2011-10-02), pages 1-12, XP055106336, Sandefjord, Norway Extrait de l'Internet: URL:http://www.wirescan.no/sites/default/f iles/EHPG2011_CableAgingReview_0.pdf [extrait le 2014-03-10] cité dans la demande**
• **STEINER J P ET AL: "An automated fault locating system", PROCEEDINGS OF THE POWER ENGINEERING SOCIETY TRANSMISSION AND DISTRIBUTION CONFERENCE. DALLAS, SEPT. 22 - 27, 1991; [PROCEEDINGS OF THE POWER ENGINEERING SOCIETY TRANSMISSION AND DISTRIBUTION CONFERENCE], NEW YORK, IEEE, US, vol. -, 22 septembre 1991 (1991-09-22), pages 219-230, XP010053880, DOI: 10.1109/TDC.1991.169511 ISBN: 978-0-7803-0219-8**

**Description**

La présente invention concerne le domaine des systèmes et procédés de diagnostic pour câble. Plus précisément l'invention concerne les méthodes de réflectométrie permettant de détecter et/ou localiser les défauts impactant un câble.

L'invention s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées, en toron de câble ou autre. L'invention peut également s'appliquer à des câbles mécaniques, par exemple des câbles de soutien d'infrastructures telles un ascenseur ou un pont.

Les méthodes de réflectométrie temporelle ou fréquentielle connues sont particulièrement adaptées à la détection de défauts francs dans un câble, tel un court circuit ou un circuit ouvert ou plus généralement une modification locale significative de l'impédance du câble. La détection du défaut se fait par la mesure de l'amplitude du signal réfléchi sur ce défaut qui est d'autant plus importante et donc détectable, que le défaut est franc.

A l'inverse, un défaut non franc, par exemple résultant d'une dégradation superficielle de la gaine du câble, d'un frottement ou d'un échauffement, engendre un pic d'amplitude faible sur le signal de réflectométrie réfléchi et est par conséquent plus difficilement détectable par des méthodes temporelles classiques.

On connait la méthode de réflectométrie dite LIRA (Line Resonance Analysis) telle que décrite par exemple dans l'article « Overview of the Halden Reactor Project Activities on Cable Aging Management and Condition Monitoring », Paolo F. Fantoni. Cette méthode est basée sur l'utilisation d'un signal de test dont on fait varier la fréquence pour mesurer sur le signal réfléchi le déphasage obtenu en fonction de la variation de fréquence. A partir de cette mesure de déphasage, il est possible de détecter un comportement inattendu qui peut être associé à un défaut non franc.

Cette méthode se limite à l'utilisation de signaux de réflectométrie fréquentielle et présente notamment l'inconvénient de ne pas pouvoir être utilisé simultanément au fonctionnement normal du câble mais de nécessiter une interruption de fonctionnement pour réaliser le test.

Les documents US2005/0234662A1 et US2005/01565585A1 divulguent des procédés de détection et de localisation des défauts dans des câbles par réflectométrie fréquentielle, dans lesquels des coefficients de réflexion sont estimés.

L'invention vise à fournir une solution permettant la caractérisation de défauts non francs, c'est-à-dire de défauts qui engendrent une modification locale non significative de l'impédance caractéristique du câble.

L'invention se base sur le calcul de l'atténuation d'un signal se propageant le long du câble sous test pour élaborer une fonction de détection dans laquelle les pics d'amplitude associés aux défauts non francs sont renforcés.

L'invention présente notamment les avantages suivants. Elle est compatible avec des méthodes de réflectométrie temporelle, fréquentielle ou de méthodes adaptées pour ne pas perturber le fonctionnement nominal du câble telles que la méthode MCTDR (Multi Carrier Time Domain Reflectometry). Elle peut fonctionner en temps réel sur des mesures réalisées à partir d'un signal injecté au sein du câble puis réfléchi mais également sur des signaux simulés. L'invention peut également s'appliquer au diagnostic de liaisons point à point mais également de réseaux filaires. Elle est indépendante de la forme d'onde du signal de réflectométrie utilisé. L'invention permet également de suivre l'évolution dans le temps d'un défaut non franc.

L'invention a pour objet un procédé de réflectométrie pour l'identification d'au moins un défaut impactant un câble en au moins un point, caractérisé en ce qu'il comporte les étapes suivantes :

- Une étape d'estimation d'un paramètre caractéristique de la propagation d'un signal se propageant dans ledit câble, parmi lesquels l'atténuation $\alpha(f)$, le facteur de phase $\beta(f)$, le coefficient de réflexion $\Gamma_{in}(f)$ ramené en entrée du câble duquel est soustrait une estimée dudit coefficient de réflexion en l'absence de défauts ou une fonction, linéaire ou non linéaire, de l'un quelconque de ces paramètres ou d'une combinaison de plusieurs de ces paramètres, ladite estimation étant réalisée en fonction de la fréquence dudit signal à partir d'un réflectogramme dudit signal,
- Une étape de transformation de l'estimée dudit paramètre du domaine fréquentiel vers le domaine temporel,
- Une étape d'identification des défauts impactant le dit câble à partir de l'identification des pics d'amplitude de l'estimée dudit paramètre transformée dans le domaine temporel.

Selon un mode particulier de réalisation, le procédé selon l'invention comporte en outre une étape de détection de défauts consistant à comparer l'amplitude de l'estimée dudit paramètre transformée dans le domaine temporel à au moins un seuil prédéterminé, un défaut étant détecté lorsque ledit seuil est dépassé.

Selon un mode particulier de réalisation, le procédé selon l'invention comporte en outre une étape de localisation de défauts à partir de l'abscisse temporelle des pics d'amplitude détectés.

Selon un mode particulier de réalisation, le procédé selon l'invention comporte en outre une étape supplémentaire de multiplication de l'estimée dudit paramètre transformée dans le domaine temporel par ledit réflectogramme dans le domaine temporel.

Selon un mode particulier de réalisation de l'invention, ledit paramètre est égal à l'atténuation α(f) ou au facteur de phase β(f) et l'étape d'estimation dudit paramètre en fonction de sa fréquence est réalisée au moins à partir d'une estimée de la longueur du câble, de la fonction de transfert fréquentielle H(f) du câble et du coefficient de réflexion sur la sortie du câble.

Selon un mode particulier de réalisation de l'invention, l'étape d'estimation de l'atténuation a(f) d'un signal en fonction de sa fréquence est réalisée en exécutant au moins le calcul suivant : $\alpha(f) = \frac{1}{2l} \ln \left| \frac{\Gamma_s(f)}{H(f)} \right|$ avec l une estimée de la longueur du câble, H(f) une estimée de la fonction de transfert fréquentielle du câble, $\Gamma_s(f)$ une estimée du coefficient de réflexion sur la sortie du câble.

Selon un mode particulier de réalisation de l'invention, ledit réflectogramme est fréquentiel et l'estimée de la fonction de transfert fréquentielle du câble est égale audit réflectogramme.

Selon un mode particulier de réalisation de l'invention, ledit paramètre est égal au facteur de propagation du signal ou à la vitesse de phase du signal ou à l'impédance d'entrée.

Selon un mode particulier de réalisation de l'invention, ledit paramètre est égal au coefficient de réflexion $\Gamma_{in}(f)$ ramené en entrée du câble, ledit coefficient étant déterminé à partir du calcul de la fonction de transfert fréquentielle H(f) du câble.

Selon un mode particulier de réalisation, le procédé selon l'invention comporte en outre une étape d'injection d'un signal dans le câble et de mesure du signal injecté réfléchi afin de produire ledit réflectogramme.

L'invention a également pour objet un système de réflectométrie comprenant des moyens adaptés pour mettre en oeuvre le procédé de réflectométrie selon l'invention, un programme d'ordinateur comportant des instructions pour l'exécution du procédé de réflectométrie selon l'invention, lorsque le programme est exécuté par un processeur et un support d'enregistrement lisible par un processeur sur lequel est enregistré un programme comportant des instructions pour l'exécution du procédé de réflectométrie selon l'invention, lorsque le programme est exécuté par un processeur.

D'autres caractéristiques et avantages de la présente invention apparaîtront mieux à la lecture de la description qui suit en relation aux dessins annexés qui représentent :

- La figure 1, un schéma de principe d'une méthode de réflectométrie pour la détection de défauts impactant un câble sous test,
- La figure 2, un diagramme de plusieurs réflectogrammes temporels illustrant la difficulté de la détection de défauts non francs,
- La figure 3, un organigramme des étapes de mise en oeuvre du procédé de détection de défauts non francs selon l'invention,
- Les figures 4a,4b et 4c, trois diagrammes illustrant respectivement sur un exemple d'application, un réflectogramme avant application du procédé selon l'invention, un réflectogramme obtenu à une étape intermédiaire du procédé selon l'invention et un réflectogramme obtenu après application du procédé selon l'invention,
- La figure 5, un synoptique d'un système de réflectométrie comprenant des moyens adaptés pour mettre en oeuvre le procédé selon l'invention

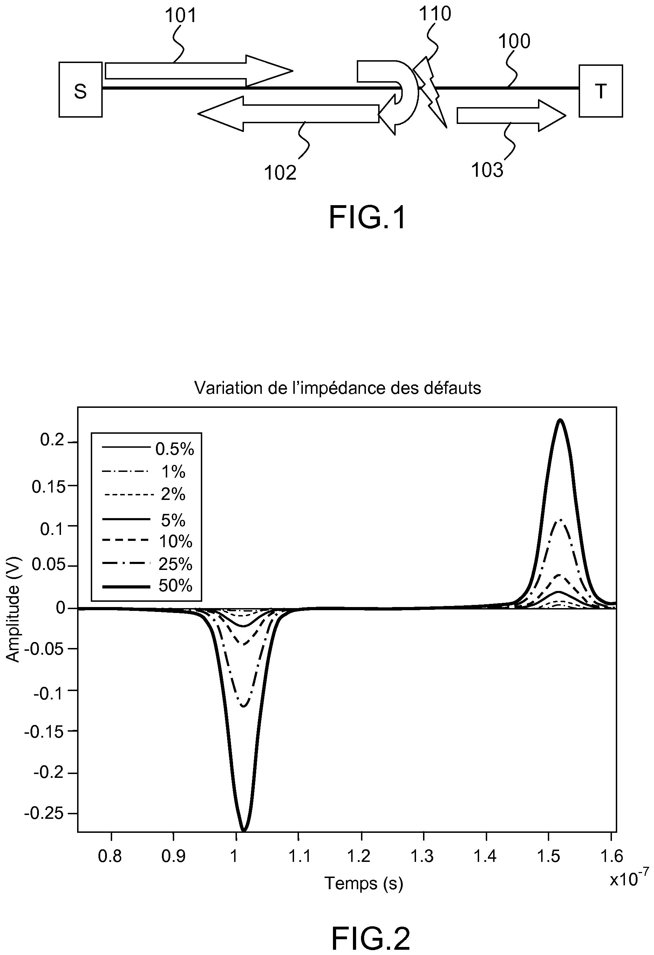

La figure 1 représente un schéma de principe d'une méthode de réflectométrie pour la détection d'un défaut impactant un câble 100.

Un système de réflectométrie S est utilisé pour injecter un signal de test 101, en un point du câble, par exemple à son extrémité. Le signal de test 101 se propage le long du câble et vient se réfléchir sur une singularité 110 du câble.

Une singularité dans un câble correspond à une rupture des conditions de propagation du signal dans ce câble. Elle résulte le plus souvent d'un défaut qui impacte localement l'impédance caractéristique du câble en provoquant une discontinuité dans ses paramètres linéaires.

Une partie du signal 103 continue à se propager jusqu'à l'extrémité du câble T. Une autre partie du signal 102 est réfléchie sur la singularité et est rétropropagée jusqu'à un point d'acquisition qui peut être confondu avec le point d'injection.

Une mesure effectuée sur le signal rétropropagé, appelée réflectogramme, est utilisée pour identifier des pics d'amplitude qui sont associés à un défaut. Le retard entre l'injection du signal 101 et l'acquisition du signal réfléchi 102 permet d'identifier, grâce au réflectogramme, la distance entre le point d'injection et le défaut.

Les méthodes de réflectométrie connues peuvent être temporelles ou fréquentielles et peuvent utiliser divers signaux de test adaptés aux contraintes du câble à tester ou permettant de ne pas perturber le fonctionnement nominal du câble.

Les systèmes de réflectométrie usuels offrent de bonnes performances pour la détection de défauts francs, autrement dit des défauts résultant d'un court-circuit, d'un circuit ouvert, d'une fin de câble ou d'une charge adaptée.

Cependant, les méthodes connues ne permettent pas de détecter, avec une fiabilité suffisante, les défauts non francs, c'est-à-dire des défauts qui résultent d'une coupure superficielle du câble, d'un échauffement, d'un frottement ou des défauts qui, de manière générale, n'impactent pas de façon aussi significative qu'un défaut franc l'impédance caractéristique locale du câble.

La figure 2 représente un exemple de réflectogramme temporel obtenu pour un câble présentant deux défauts non francs dont l'impédance locale varie entre 0,5% et 50% de l'impédance du câble. On remarque par l'analyse des différentes courbes que plus l'impédance locale liée au défaut non franc est faible plus l'amplitude du pic associé sur le réflectogramme est également faible et donc sera difficile à détecter.

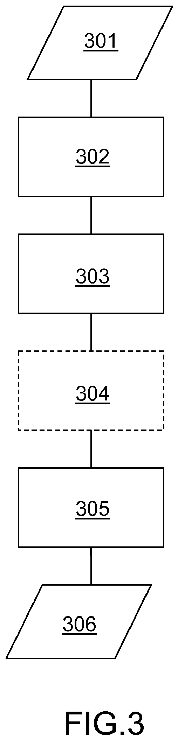

La figure 3 schématise, sur un organigramme, les étapes de mise en oeuvre du procédé de réflectométrie selon un mode de réalisation particulier de l'invention.

L'invention est décrite selon un mode de réalisation particulier basé sur le calcul de l'atténuation a(f) d'un signal dans un câble qui correspond à une réduction de l'amplitude et de l'énergie de ce signal au cours de sa propagation le long du câble. Sans sortir du cadre de l'invention, d'autres paramètres peuvent être utilisés en remplacement de l'atténuation, comme cela sera explicité plus loin.

L'atténuation est une valeur, variable en fréquence, reliant l'amplitude du signal réfléchi 102 avec l'amplitude du signal injecté 101 à l'extrémité du câble. L'atténuation est une grandeur physique qui sert en général à dimensionner la longueur d'un câble ou l'amplitude nécessaire du signal injecté dans le câble pour qu'il puisse être mesuré en sortie du câble avec une amplitude suffisante. Par la suite, on parlera d'atténuation d'un câble pour désigner l'atténuation d'un signal se propageant dans ce câble.

Lorsque l'on mesure les caractéristiques d'un câble, il est possible d'estimer l'atténuation qu'il génère sur la bande de fréquence utile du signal d'injection. Cela se fait à partir de la fonction de transfert H(f) du câble. Cette fonction de transfert peut être directement obtenue par la mesure du réflectogramme, lorsque la méthode utilisée est une méthode de réflectométrie fréquentielle. Lorsqu'on utilise une méthode de réflectométrie temporelle, la fonction de transfert H(f) peut être calculée comme le rapport entre la transformée en fréquence du signal réfléchi et la transformée en fréquence du signal injecté. La transformée en fréquence d'un signal peut, par exemple, être déterminée par le biais d'une transformée de Fourier directe.

La fonction de transfert H(f) d'un câble point à point adapté en entrée, de longueur l et sans défaut, fait intervenir le coefficient de réflexion $\Gamma s(f)$ sur la sortie du câble, le facteur de phase $\beta(f)$ et l'atténuation $\alpha(f)$. La fonction de transfert H(f) peut être déterminée à l'aide de l'équation suivante, bien connue du domaine de la transmission de signaux électriques dans un câble.

$$H(f) = \Gamma_s(f)e^{-2l(\alpha(f)+j\beta(f))} \quad (1)$$

L'atténuation a(f) peut donc être isolée à partir de l'équation (1) :

$$\alpha(f) = \frac{1}{2l}\ln\left|\frac{\Gamma_s(f)}{H(f)}\right| \quad (2)$$

Lorsqu'il y a présence de défauts sur le câble, la fonction de transfert H(f) est modifiée par l'ajout de termes $t_i(f)$ prenant en compte la transmission du signal à travers les défauts ainsi que de termes $\Gamma_i(f)$ prenant en compte la réflexion d'une partie du signal sur chacun des défauts. En supposant que les réflexions multiples introduites par la présence des défauts sont négligeables, la fonction de transfert prend la forme suivante :

$$H(f) = \sum_i^{nb\,défauts} t_i(f)\Gamma_i(f)e^{-2l_i(\alpha(f)+j\beta(f))} + t_s(f)\Gamma_s(f)e^{-2l(\alpha(f)+j\beta(f))}$$

avec $t_s(f)$ et $\Gamma_s(f)$, les coefficients respectifs de transmission et de réflexion sur la fin du câble.

En recalculant l'atténuation avec la formule de la relation (2), on obtient :

$$\alpha(f) = \alpha_{th}(f) - \frac{1}{2l}\ln\left[\left|\frac{\sum_i^{nb\,défauts} t_i(f)\Gamma_i(f)e^{2(l-l_i)(\alpha(f)+j\beta(f))}+t_s(f)\Gamma_s(f)}{\Gamma_s(f)}\right|\right] \quad (3)$$

avec $\alpha_{th}(f)$ l'atténuation du câble en l'absence de défauts.

A partir de la relation (3), on peut en déduire une modélisation plus générale de l'atténuation α(f) du câble en présence de défauts :

$$\alpha(f) = \alpha_{th}(f)$$
$$-\frac{1}{4l}\ln\sum_i^{nb\ défauts+1}\left[A_i(f) + \sum_{k=i}^{nb\ defauts+1} B_k(f)\cos(2\beta(f)(l_k - l_i))\right] \quad (4)$$

Le terme $(l_k-l_i)$ correspond à la distance entre deux défauts.

La modélisation donnée par la relation (4) permet de déduire que l'atténuation du câble en présence de défauts est égale à une somme entre l'atténuation théorique du câble en l'absence de défauts et une somme de termes oscillants de plus ou moins grande amplitude selon l'importance du défaut et de sa position dans le câble, et de période dépendante de l'éloignement entre le défaut et la fin de câble.

Cette modélisation permet de déduire que l'atténuation du câble peut être utilisée comme fonction de détection d'un défaut par le biais de la détection des pics d'amplitudes fréquentiels associés aux termes oscillants du modèle de la relation (4).

Cette constatation est à la base du procédé selon l'invention schématisé par l'organigramme de la figure 3.

Sans sortir du cadre de l'invention, lorsque le câble utilisé n'est pas adapté en entrée, il est possible de se ramener au cas de figure décrit ci-dessus en adaptant l'impédance d'entrée via toute méthode connue de l'Homme du métier.

Le procédé selon l'invention reçoit les données d'entrée 301 suivantes : la longueur du câble sous test ou une estimée de cette longueur ainsi qu'une estimée de la fonction de transfert fréquentielle du câble et des coefficients de réflexion en entrée et en sortie.

Selon un mode de réalisation particulier de l'invention, la longueur du câble peut être déterminée par l'application d'une méthode de réflectométrie permettant de localiser un défaut franc, par exemple la terminaison du câble, et d'estimer la vitesse de propagation du signal dans le câble. Une méthode de réflectométrie possible est celle décrite dans le brevet français du Demandeur publié sous le numéro FR 2964246 et intitulé « procédé et dispositif de mesure automatique des caractéristiques physiques d'un câble, en particulier de la vitesse de propagation ». Toute autre méthode alternative permettant d'obtenir une estimation de la longueur du câble peut être utilisée.

Dans une première étape 302, on calcule une estimée de l'atténuation du câble en fonction des paramètres précités. Selon un mode de réalisation particulier, cette estimée est calculée à l'aide de la relation (2). Comme indiqué précédemment, la fonction de transfert fréquentielle du câble peut être déterminée directement ou indirectement à partir d'un réflectogramme mesuré pour le câble sous test. Le réflectogramme peut être mesuré à partir de l'acquisition d'un signal réfléchi dans le câble. Il peut également être pré-calculé et sauvegardé pour être utilisé par le procédé selon l'invention. Il peut également être obtenu par simulation des caractéristiques physiques d'un câble.

Dans une deuxième étape 303, on calcule une fonction de détection des défauts impactant le câble. Cette fonction de détection est égale à la transformée fréquentielle inverse de l'atténuation calculée à l'étape 302. Autrement dit l'atténuation calculée à l'étape 302 est convertie du domaine fréquentiel vers le domaine temporel. Comme explicité à l'appui des équations (1) à (4), la fonction de détection calculée présente des pics d'amplitude associés aux défauts du câble. Leur identification permet la détection de ces défauts. La mesure du délai entre le pic relatif au point d'injection et le pic associé à un défaut permet la localisation de ce défaut et son suivi au cours du temps.

Dans une étape optionnelle 304, la fonction de détection calculée est améliorée par une multiplication de cette fonction avec un réflectogramme temporel utilisé pour calculer la fonction de transfert fréquentielle.

Cette étape 304 permet d'améliorer la précision de détection dans la mesure où elle a pour conséquence l'amplification des pics d'amplitude associés aux défauts non francs.

Une étape de détection 305 est ensuite réalisée en comparant la fonction de détection à un ou plusieurs seuils de détections. Le ou les seuils sont configurés de sorte à permettre la détection des pics d'amplitude associés à des défauts non francs. Ils sont également configurés de sorte à éviter de fausses détections sur des pics d'amplitude plus faibles associés aux bruits de mesure ou de calcul ou à des réflexions multiples.

Dans une dernière étape 306, les défauts sont identifiés par les pics d'amplitude qui dépassent le ou les seuils de détection. En particulier, une estimée de la localisation des défauts peut être réalisée en mesurant, sur la fonction de détection, le retard entre le premier pic correspondant au point d'injection et les pics associés aux défauts, puis en multipliant cette mesure par la vitesse de propagation du signal dans le câble ou en effectuant un rapport de proportionnalité à partir du retard mesuré entre le pic associé au point d'injection et le pic associé à la terminaison du câble (qui correspond à un défaut franc et donc à un pic de grande amplitude) et de la longueur du câble.

Selon un mode de réalisation particulier de l'invention, le calcul de l'atténuation et donc de la fonction de détection, n'est pas réalisé sur la longueur totale du câble mais seulement sur une portion du câble située entre le point d'injection et un défaut franc localisé. En effet, il est inutile de chercher à détecter des défauts non francs au delà de défauts francs qui bloquent entièrement la propagation des signaux. Pour mettre en oeuvre cette variante, une étape préalable de détection d'un défaut franc ou d'une fin de câble, par exemple un court-circuit, un circuit ouvert ou une charge adaptée, est réalisée à partir d'un réflectogramme obtenu par une méthode de réflectométrie connue.

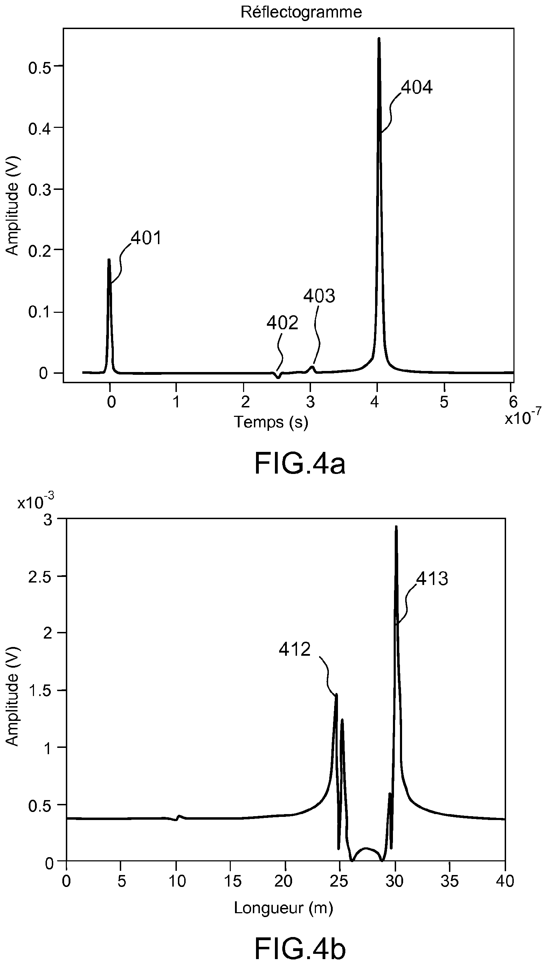

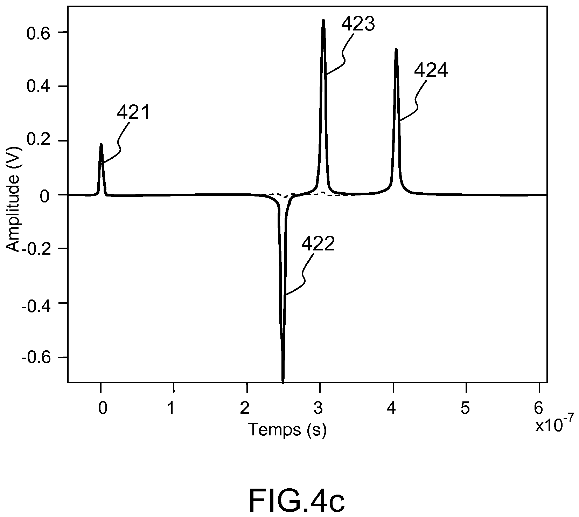

Les figures 4a,4b,4c illustrent les résultats obtenus par application du procédé selon l'invention pour un exemple donné qui concerne un câble coaxial d'impédance 75 ohms branché sur une entrée d'impédance 50 ohms et présentant deux défauts non francs situés à 25 et 30 mètres, en circuit ouvert en bout de ligne. L'impulsion de signal injecté a une largeur de 5 nanosecondes.

Les défauts non francs sont, par exemple, conséquents à la fixation d'un objet en aluminium sur le câble, de la mise à nu du conducteur du câble , de la torsion ou du pincement de ce dernier.

La figure 4a représente le réflectogramme temporel obtenu par application d'une méthode de réflectométrie usuelle. On identifie sur ce réflectogramme un premier pic franc 401 à l'abscisse 0 correspondant au point d'injection, un second pic franc 404 correspondant à la fin du câble (circuit ouvert) et deux pics de faible amplitude 402,403 correspondant à deux défauts non francs. On voit que la détection des pics 402,403 n'est pas aisée du fait de leur très faible amplitude.

La figure 4b représente la fonction de détection obtenue à l'issue de l'étape 303 du procédé selon l'invention. Le diagramme de la figure 4b représente l'amplitude de la fonction de détection en fonction de la longueur. Par un simple rapport de proportionnalité, la fonction de détection peut aussi être représentée en fonction du temps. On remarque sur la figure 4b, que les deux pics 412,413 associés aux défauts non francs sont fortement amplifiés par rapport au réflectogramme classique de la figure 4a. Ainsi, la fonction de détection représentée à la figure 4b permet déjà d'identifier les deux défauts non francs.

La figure 4c représente, sur un diagramme amplitude-temps, le réflectogramme amélioré obtenu en multipliant le réflectogramme initial de la figure 4a avec la fonction de détection représentée à la figure 4c. Le réflectogramme obtenu in fine permet toujours d'identifier les pics d'amplitude 421,424 associés aux défauts francs mais également ceux 422,423 associés aux défauts non francs.

Sans sortir du cadre de l'invention, le procédé peut s'appliquer de façon analogue en remplaçant l'atténuation du signal par d'autres paramètres physiques du signal comme par exemple le facteur de phase β(f) de la fonction de transfert H(f). En effet, la démonstration effectuée ci-dessus pour l'atténuation α(f) est également valable pour le facteur de phase β(f). Autrement dit, le facteur de phase, qui peut être obtenu à partir de la fonction de transfert H(f), est composé d'un terme théorique correspondant au facteur de phase en l'absence de défauts et d'une somme de termes oscillants correspondant à l'information associée à la présence de défauts non francs. Le procédé selon l'invention décrit à l'appui de la figure 3 s'applique alors de façon analogue en remplaçant, dans la première étape 302, le calcul d'une estimée de l'atténuation du câble par le calcul d'une estimée du facteur de phase qui peut par exemple être obtenu à partir de la relation (1).

De façon plus générale, l'atténuation α(f) ou le facteur de phase β(f) peut être remplacé par toute combinaison linéaire ou toute fonction linéaire ou non linéaire de l'un de ces deux paramètres ou de ces deux paramètres conjointement.

Par exemple, le procédé selon l'invention s'applique également en remplaçant l'atténuation α(f) par le facteur de propagation γ(f) qui a pour partie réelle l'atténuation α(f) et pour partie imaginaire le facteur de phase β(f) ou en remplaçant l'atténuation par la vitesse de phase Vp(f)= $2\pi f/ \beta(f)$ qui est une fonction du facteur de phase.

Dans un autre mode de réalisation de l'invention, le procédé peut également s'appliquer en remplaçant l'atténuation α(f) par le coefficient de réflexion Γ$_{in}$(f) ramené en entrée du câble qui est directement égal à la fonction de transfert H(f). Dans ce cas, il est nécessaire de soustraire au coefficient de réflexion Γ$_{in}$(f) mesuré, une estimée du coefficient de réflexion en l'absence de défauts.

Toute fonction linéaire ou non linéaire du coefficient de réflexion peut, de façon analogue, être utilisée pour appliquer le procédé selon l'invention. Par exemple, l'impédance d'entrée du câble est définie par la relation

$$Z_{in} = Z_0 \cdot \frac{(1+\Gamma in(f))}{(1-\Gamma in(f))},$$ où $Z_0$ est l'impédance d'entrée du câble et est un exemple de fonction du coefficient de réflexion ramené en entrée du câble.

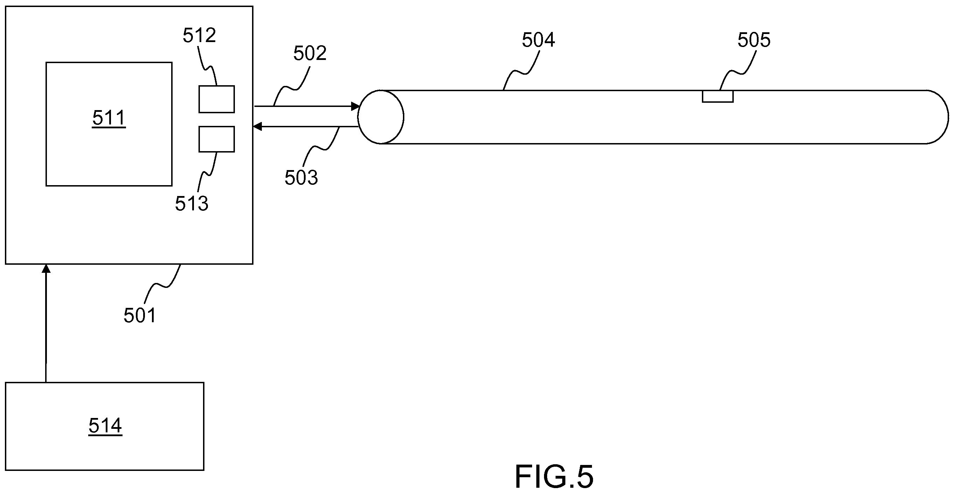

La figure 5 décrit un synoptique d'un exemple de système de réflectométrie selon l'invention.

Un câble à tester 504 présente un défaut non franc 505 à une distance quelconque d'une extrémité du câble.

Le système de réfléctométrie 501 selon l'invention comprend un composant électronique 511 de type circuit intégré, tel un circuit à logique programmable, par exemple de type FPGA, ou micro-contrôleur, adapté à exécuter deux fonctions. D'une part, le composant 511 permet de générer un signal de réflectométrie s(t) à injecter dans le câble 504 sous test. Ce signal généré numériquement est ensuite converti via un convertisseur numérique-analogique 512 puis injecté 502 à une extrémité 506 du câble. Le signal s(t) se propage dans le câble et est réfléchi sur la singularité engendrée par le défaut 505. Le signal réfléchi est rétropropagé jusqu'au point d'injection 506 puis capturé 503, converti numériquement via un convertisseur analogique-numérique 513, et transmis au composant 511. Le composant électronique 511 est en outre adapté à exécuter les étapes du procédé selon l'invention décrit ci-dessus afin de produire, à partir du signal s(t) reçu, un réflectogramme temporel qui peut être transmis à une unité de traitement 514, de type ordinateur, assistant numérique personnel ou autre pour afficher les résultats des mesures sur une interface homme-machine.

Le système 501 décrit à la figure 1 est un exemple de réalisation nullement limitatif. En particulier les deux fonctions exécutées par le composant 511 peuvent être séparées dans deux composants ou dispositifs distincts. Le système peut également fonctionner avec des signaux analogiques, dans ce cas les convertisseurs analogique-numérique et numérique-analogique ne sont pas nécessaires. Au lieu d'injecter et/ou de mesurer le signal réfléchi à une extrémité du câble sous test, il est également possible de réaliser l'injection ou la mesure du signal réfléchi en un point quelconque du câble.

Le système de réflectométrie selon l'invention peut également être constitué d'un équipement portatif, du type tablette tactile ou téléphone intelligent couplé à des moyens de connexion à un câble.

Le procédé selon l'invention peut être implémenté, dans le composant électronique 511 à partir d'éléments matériel et/ou logiciel. Il peut notamment être mis en oeuvre en tant que programme d'ordinateur comportant des instructions pour son exécution. Le programme d'ordinateur peut être enregistré sur un support d'enregistrement lisible par un processeur.

Il peut également être exécuté à partir d'un réflectogramme simulé ou obtenu par des moyens externes, dans ce cas le composant électronique 511 peut être dissocié du système de réflectométrie lui-même.

**Revendications**

1. Procédé de réflectométrie pour l'identification d'au moins un défaut impactant un câble en au moins un point, comportant les étapes suivantes :

    - Une étape (302) d'estimation d'un paramètre caractéristique de la propagation d'un signal se propageant dans ledit câble, parmi lesquels l'atténuation $\alpha(f)$, le facteur de phase $\beta(f)$, le coefficient de réflexion $\Gamma_{in}(f)$ ramené en entrée du câble duquel est soustrait une estimée dudit coefficient de réflexion en l'absence de défauts ou une fonction, linéaire ou non linéaire, de l'un quelconque de ces paramètres ou d'une combinaison de plusieurs de ces paramètres, ladite estimation étant réalisée en fonction de la fréquence dudit signal à partir d'un réflectogramme dudit signal,
    - Une étape (303) de transformation de l'estimée dudit paramètre du domaine fréquentiel vers le domaine temporel,
    - Une étape (305,306) d'identification des défauts impactant le dit câble à partir de l'identification des pics d'amplitude de l'estimée dudit paramètre transformée dans le domaine temporel.

2. Procédé de réflectométrie selon la revendication 1 comportant une étape de détection (305) de défauts consistant à comparer l'amplitude de l'estimée dudit paramètre transformée dans le domaine temporel à au moins un seuil prédéterminé, un défaut étant détecté lorsque ledit seuil est dépassé.

3. Procédé de réflectométrie selon la revendication 2 comportant une étape de localisation (306) de défauts à partir de l'abscisse temporelle des pics d'amplitude détectés.

4. Procédé de réflectométrie selon l'une des revendications précédentes comportant une étape supplémentaire (304) de multiplication de l'estimée dudit paramètre transformée dans le domaine temporel par ledit réflectogramme dans le domaine temporel.

5. Procédé de réflectométrie selon l'une des revendications précédentes dans lequel ledit paramètre est égal à l'atténuation $\alpha(f)$ ou au facteur de phase $\beta(f)$ et l'étape (302) d'estimation dudit paramètre en fonction de sa fréquence est réalisée au moins à partir d'une estimée de la longueur du câble, de la fonction de transfert fréquentielle H(f) du câble et du coefficient de réflexion sur la sortie du câble.

6. Procédé de réflectométrie selon la revendication 5 dans lequel l'étape (302) d'estimation de l'atténuation $\alpha(f)$ d'un signal en fonction de sa fréquence est réalisée en exécutant au moins le calcul suivant : $\alpha(f) = \frac{1}{2l} \ln \left| \frac{\Gamma_s(f)}{H(f)} \right|$

   avec l une estimée de la longueur du câble, H(f) une estimée de la fonction de transfert fréquentielle du câble, $\Gamma_s(f)$ une estimée du coefficient de réflexion sur la sortie du câble.

7. Procédé de réflectométrie selon l'une des revendications 5 ou 6 dans lequel ledit réflectogramme est fréquentiel et l'estimée de la fonction de transfert fréquentielle du câble est égale audit réflectogramme.

8. Procédé de réflectométrie selon l'une des revendications 1 à 4 dans lequel ledit paramètre est égal au facteur de propagation du signal ou à la vitesse de phase du signal ou à l'impédance d'entrée.

9. Procédé de réflectométrie selon l'une des revendications 1 à 4 dans lequel ledit paramètre est égal au coefficient de réflexion $\Gamma_{in}(f)$ ramené en entrée du câble duquel est soustrait une estimée dudit coefficient de réflexion lorsque ledit câble est sain, ledit coefficient étant déterminé à partir du calcul de la fonction de transfert fréquentielle H(f) du câble.

10. Procédé de réflectométrie selon l'une des revendications précédentes comportant une étape (300) d'injection d'un signal dans le câble et de mesure du signal injecté réfléchi afin de produire ledit réflectogramme,

11. Système de réflectométrie comprenant des moyens adaptés pour mettre en oeuvre le procédé de réflectométrie selon la revendication 10.

12. Programme d'ordinateur comportant des instructions pour l'exécution du procédé de réflectométrie selon l'une quelconque des revendications 1 à 9, lorsque le programme est exécuté par un processeur.

13. Support d'enregistrement lisible par un processeur sur lequel est enregistré un programme comportant des instructions pour l'exécution du procédé de réflectométrie selon l'une quelconque des revendications 1 à 9, lorsque le programme est exécuté par un processeur.

**Patentansprüche**

1. Reflektometrieverfahren zur Identifizierung mindestens eines Fehlers in einem Kabel an mindestens einem Punkt, welches folgende Schritte beinhaltet:

   - einen Schritt (302) des Schätzens eines charakteristischen Parameters der Fortpflanzung eines Signals, welches sich in dem Kabel fortpflanzt, darunter die Dämpfung $\alpha(f)$, der Phasenfaktor $\beta(f)$, der Reflexionskoeffizient $\Gamma_{in}(f)$ am Eingang des Kabels, von welchem eine Schätzung des Reflexionskoeffizienten bei Nichtvorliegen von Fehlern, oder eine lineare oder nichtlineare Funktion eines dieser Parameter oder einer Kombination dieser Parameter abgezogen wird, wobei die Schätzung angesichts der Frequenz des Signals anhand eines Reflektogramms des Signals erstellt wird,
   - einen Schritt (303) der Transformation der Schätzung des Parameters vom Frequenzbereich in den Zeitbereich,
   - einen Schritt (305, 306) des Identifizierens von Fehlern in dem Kabel anhand der Identifizierung der Amplitudenspitzen der Schätzung des Parameters nach Transformation in den Zeitbereich.

2. Reflektometrieverfahren nach Anspruch 1, beinhaltend einen Schritt des Erkennens (305) von Fehlern, darin bestehend, die Amplitude der Schätzung des Parameters nach Transformation in den Zeitbereich mit mindestens einem vorbestimmten Schwellenwert zu vergleichen, wobei ein Fehler erkannt wird, wenn der Schwellenwert überschritten wird.

3. Reflektometrieverfahren nach Anspruch 2, beinhaltend einen Schritt des Lokalisierens (306) von Fehlern anhand der Zeitabszisse der erkannten Amplitudenspitzen.

4. Reflektometrieverfahren nach einem der vorhergehenden Ansprüche, beinhaltend einen zusätzlichen Schritt (304) des Multiplizierens der Schätzung des Parameters nach Transformation in den Zeitbereich mit dem Reflektogramm im Zeitbereich.

5. Reflektometrieverfahren nach einem der vorhergehenden Ansprüche, bei welchem der Parameter gleich der Dämpfung $\alpha(f)$ oder dem Phasenfaktor $\beta(f)$ ist und der Schritt (302) des Schätzens des Parameters angesichts seiner Frequenz mindestens anhand einer Schätzung der Länge des Kabels, der Frequenzübertragungsfunktion H(f) des Kabels und des Reflexionskoeffizienten am Ausgang des Kabels erfolgt.

6. Reflektometrieverfahren nach Anspruch 5, bei welchem der Schritt (302) des Schätzens der Dämpfung $\alpha(f)$ eines Signals angesichts seiner Frequenz erfolgt, indem mindestens folgende Berechnung angestellt wird:

$$\alpha(f) = \frac{1}{2l} \ln \left| \frac{\Gamma_s(f)}{H(f)} \right|$$

wobei 1 eine Schätzung der Länge des Kabels, H(f) eine Schätzung der Frequenzübertragungsfunktion des Kabels, $\Gamma_s(f)$ eine Schätzung des Reflexionskoeffizienten am Ausgang des Kabels ist.

7.  Reflektometrieverfahren nach einem der Ansprüche 5 oder 6, bei welchem das Reflektogramm frequenzgebunden ist und die Schätzung der Frequenzübertragungsfunktion des Kabels gleich dem Reflektogramm ist.

8.  Reflektometrieverfahren nach einem der Ansprüche 1 bis 4, bei welchem der Parameter gleich dem Fortpflanzungsfaktor des Signals oder gleich der Phasengeschwindigkeit des Signals oder der Eingangsimpedanz ist.

9.  Reflektometrieverfahren nach einem der Ansprüche 1 bis 4, bei welchem der Parameter gleich dem Reflexionsko-effizienten $\Gamma_{in}(f)$ am Eingang des Kabels ist, von welchem eine Schätzung des Reflexionskoeffizienten abgezogen wird, wenn das Kabel intakt ist, wobei der Koeffizient anhand der Berechnung der Frequenzübertragungsfunktion H(f) des Kabels bestimmt wird.

10. Reflektometrieverfahren nach einem der vorhergehenden Ansprüche, beinhaltend einen Schritt (300) des Einspeisens eines Signals in das Kabel und des Messens des eingespeisten, reflektierten Signals zum Erzeugen des Reflektogramms.

11. Reflektometriesystem, beinhaltend Mittel, welche zur Umsetzung des Reflektometrieverfahrens nach Anspruch 10 geeignet sind.

12. Computerprogramm, beinhaltend Anweisungen zur Ausführung des Reflektometrieverfahrens nach einem der Ansprüche 1 bis 9, wenn das Programm von einem Prozessor ausgeführt wird.

13. Aufzeichnungsträger, welcher durch einen Prozessor lesbar ist, auf welchem ein Programm aufgezeichnet ist, welches Anweisungen zur Ausführung des Reflektometrieverfahrens nach einem der Ansprüche 1 bis 9 beinhaltet, wenn das Programm von einem Prozessor ausgeführt wird.

**Claims**

1.  A reflectometry method for identifying at least one fault affecting a cable at at least one point, **characterized in that** it comprises the following steps:

    - a step (302) for estimating a parameter characteristic of the propagation of a signal propagating within said cable, amongst which are the attenuation $\alpha(f)$, the phase factor $\beta(f)$, the reflection coefficient $\Gamma_{in}(f)$ seen at the input of the cable from which is subtracted an estimate of said reflection coefficient in the absence of faults or a function, linear or non-linear, of the any one of these parameters or of a combination of several of these parameters, said estimation being made as a function of the frequency of said signal based on a reflectogram of said signal,
    - a step (303) for transformation of the estimate of said parameter from the frequency domain into the time domain,
    - a step (305, 306) for identification of the faults affecting said cable from the identification of the amplitude peaks of the estimate of said parameter transformed into the time domain.

2.  The reflectometry method as claimed in claim 1, comprising a step (305) for detection of faults consisting in comparing the amplitude of the estimate of said parameter transformed into the time domain with at least one predetermined threshold, a fault being detected when said threshold is exceeded.

3.  The reflectometry method as claimed in claim 2, comprising a step for localization (306) of faults from the time abscissa of the detected amplitude peaks.

4.  The reflectometry method as claimed in one of the preceding claims comprising an additional step (304) for multiplication of the estimate of said parameter transformed into the time domain by said reflectogram in the time domain.

5. The reflectometry method as claimed in one of the preceding claims in which said parameter is equal to the attenuation $\alpha(f)$ or to the phase factor $\beta(f)$ and the step (302) for estimation of said parameter as a function of its frequency is carried out at least based on an estimate of the length of the cable, on the frequency transfer function H(f) of the cable and on the reflection coefficient at the output of the cable.

6. The reflectometry method as claimed in claim 5, in which the step (302) for estimation of the attenuation $\alpha(f)$ of a signal as a function of its frequency is carried out by executing at least the following calculation:

$$\alpha(f) = \frac{1}{2l} \ln \left| \frac{\Gamma_s(f)}{H(f)} \right|$$ , with 1 an estimate of the length of the cable, H(f) an estimate of the frequency transfer function of the cable, and $\Gamma_s(f)$ an estimate of the reflection coefficient at the output of the cable.

7. The reflectometry method as claimed in either of claims 5 and 6, in which said reflectogram is in the frequency domain and the estimate of the frequency transfer function of the cable is equal to said reflectogram.

8. The reflectometry method as claimed in one of claims 1 to 4, in which said parameter is equal to the propagation factor of the signal or to the phase velocity of the signal or to the input impedance.

9. The reflectometry method as claimed in one of claims 1 to 4 in which said parameter is equal to the reflection coefficient $\Gamma_{in}(f)$ seen at the input of the cable from which an estimate of said reflection coefficient is subtracted, when said cable is intact, said coefficient being determined from the calculation of the frequency transfer function H(f) of the cable.

10. The reflectometry method as claimed in one of the preceding claims comprising a step (300) for injection of a signal into the cable and for measuring the reflected injected signal in order to produce said reflectogram.

11. A reflectometry system comprising means designed to implement the reflectometry method as claimed in claim 10.

12. A computer program comprising instructions for the execution of the reflectometry method as claimed in any one of claims 1 to 9, when the program is executed by a processor.

13. A recording medium readable by a processor on which a program is recorded comprising instructions for the execution of the reflectometry method as claimed in any one of claims 1 to 9, when the program is executed by a processor.

FIG.1

Variation de l'impédance des défauts

FIG.2

FIG.3

Réflectogramme

FIG.4a

FIG.4b

FIG.4c

FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20050234662 A1
- US 200501565585 A1
- FR 2964246